# EUROPEAN PATENT APPLICATION

(11) **EP 2 677 389 A2**
(43) Date of publication of application: **25.12.2013**
(21) Application number: 13168388.0
(22) Date of filing: 17.05.2013
(51) Int. Cl.: G06F 1/16, G06F 1/18

(54) **Electronic device**

(30) Priority: 29.05.2012 CN 201210170699
(71) Applicant: Hong Fu Jin Precision Industry (ShenZhen) Co., Ltd., Longhua Town, Bao'an District Shenzhen City Guangdong 518109 (CN); Hon Hai Precision Industry Co., Ltd., New Taipei City (TW)
(72) Inventor: Ma, Xiao-Hui, Shenzhen City, Guangdong Province (CN); Li, Xin-Ping, Shenzhen City, Guangdong Province (CN); Wang, Tao, Shenzhen City, Guangdong Province (CN); Deng, Xue-Bing, Shenzhen City, Guangdong Province (CN); Cheng, Hai-Long, Shenzhen City, Guangdong Province (CN)
(74) Representative: Gray, John James

(57) **Abstract**

An electronic device includes a main body (1), a cover (3), a pivot mechanism (2), a main circuit board (13) received in the main body (1), and a sub-circuit board (33) received in the cover (3). The pivot mechanism (2) is conductive, the main circuit board (13) includes a grounded first conductive layer (131), the sub-circuit board (33) includes a grounded second conductive layer (331), the first conductive layer (131) is connected to the second conductive layer (331).

## Description

### Description of Related Art

Electronic devices, such as portable DVD players include a main body, a display panel, and a metal pivot. The display panel is rotatably connected to the main body via the metal pivot. As display panels become miniaturized the circuit boards received in the display panel must be reduced in size as well. As a result, the electrical grounding area becomes smaller, reducing the capacity of the electro static discharge (ESD) protection for the circuit board.

Therefore, there is room for improvement in the art.

### Summary

According to an exemplary embodiment of the invention, an electronic device includes a main body, a cover, a pivot mechanism, a main circuit board received in the main body, and a sub-circuit board received in the cover. The pivot mechanism is conductive, the main circuit board comprises a grounded first conductive layer, the sub-circuit board includes a grounded second conductive layer, the first conductive layer is connected to the second conductive layer. As a result, the pivot mechanism electrically connects the second conductive layer to the first conductive layer to increase the area conduction, such that the capacity of ESD protection for the sub-circuit board is improved.

### BRIEF DESCRIPTION OF THE DRAWINGS

The components of the drawings are not necessarily drawn to scale, the emphasis instead being placed upon clearly illustrating the principles of the embodiments of an electronic device. Moreover, in the drawings, like reference numerals designate corresponding parts throughout one view.

FIG. 1 is an isometric view of an electronic device having a pivot mechanism and a sub-circuit board in accordance with an embodiment.

FIG. 2 is an exploded of an electronic device in FIG. 1.

FIG. 3 is an isometric view of the pivot mechanism in FIG. 2.

FIG. 4 is an isometric view of the sub-circuit board in FIG. 2.

FIG. 5 is an assembly view of a part of components of the electronic device in FIG. 2.

### DETAILED DESCRIPTION

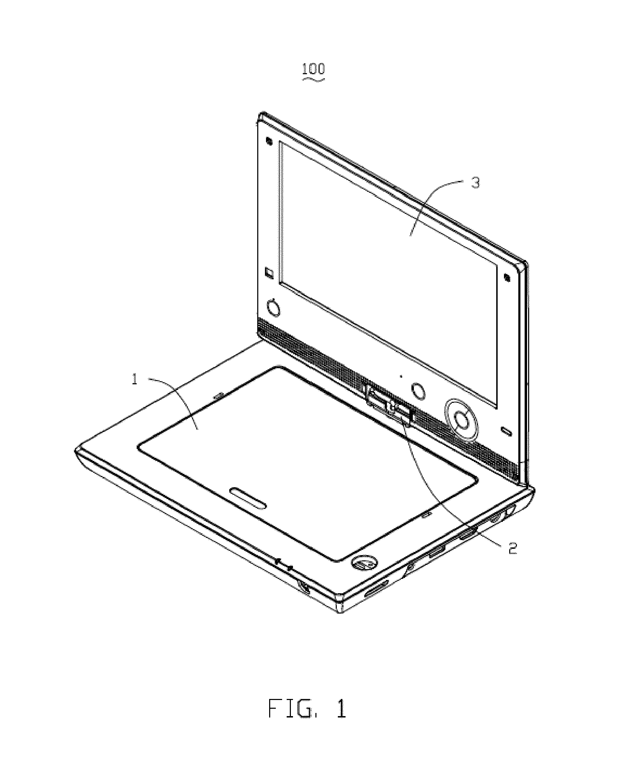

FIG. 1 is an electronic device 100 of an embodiment. The electronic device 100 includes a main body 1, a pivot mechanism 2, and a cover 3. The cover 3 is rotatably connected to the main body 1 to be opened from or folded down the main body 1. In this embodiment, the electronic device 100 is a DVD player.

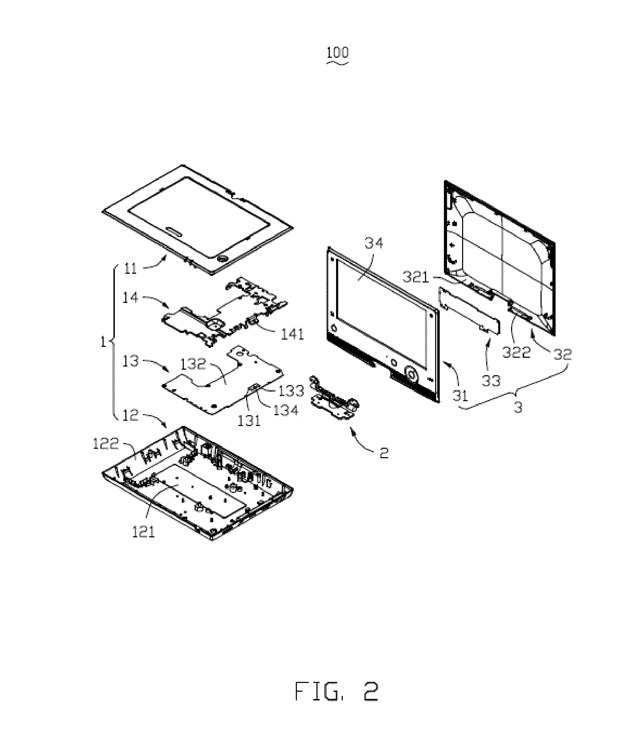

FIG. 2 shows that the main body 1 includes an upper casing 11, a lower casing 12, a main circuit board 13, and a conductive sheet 14. The lower casing 12 is rectangular and includes a bottom side 121, and a side wall 122 extending from edges of the bottom side 121. The upper casing 11 covers the lower casing 12 to form a receiving space to receive the main circuit board 13, the conductive sheet 14, and other electronic elements.

The main circuit board 13 is configured to control the main body 1 to perform corresponding functions. The main circuit board 13 includes a first conductive layer 131, and a first insulated layer 132. A first conductive portion 133 is arranged on an edge of the first conductive layer 131. The first conductive portion 133 is exposed out of the first insulated layer 132. A plurality of first through holes 134 are defined in the first conductive portion 133. The first though hole 134 runs through the main circuit board 13.

The conductive sheet 14 is flat plate, made of conductive metal material, such as aluminum. The conductive sheet 14 defines a plurality of second through holes 141 corresponding to the second through holes 134. Securing members, such as screws (not shown), pass through the first through holes 141 and the second through holes 134 to secure the conductive sheet 14 to the main circuit board 13. As a result, the conductive sheet 14 is electrically connected to the first conductive portion 133, and the first conductive layer 131 is electrically connected to the conductive sheet 14.

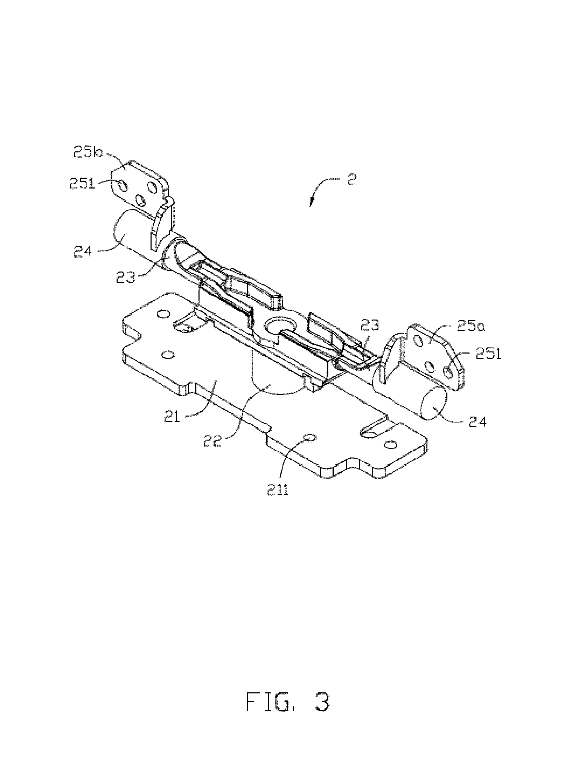

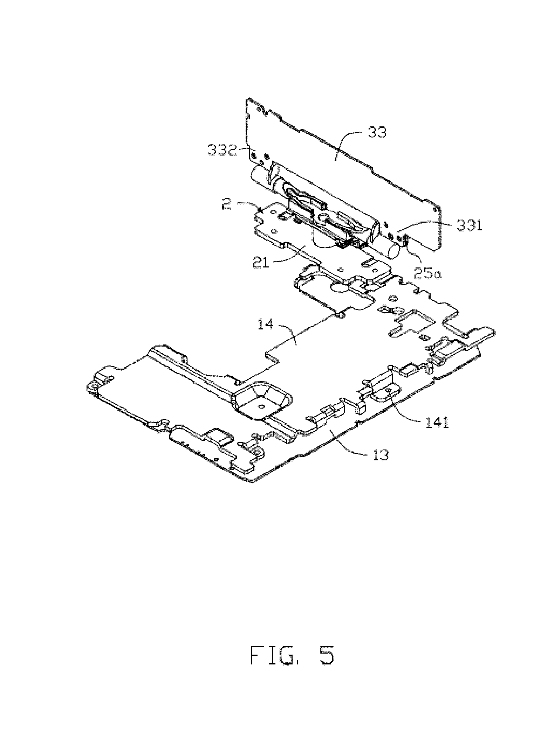

FIGs. 3 and 5 show that the pivot mechanism 2 is made of conductive metal and rigid material. The pivot mechanism 2 includes a bottom board 21, a securing part 22, a pivot shaft 23, two sleeves 24, a first wing board 25a, a second wing board 25b. Opposite ends (left and right ends) of the bottom board 21 respectively define two through holes 211. Conductive securing members, such as iron screws (not shown) pass through the through holes 211 defined in the right end of the bottom board 21 securing the bottom board 21 to the conductive sheet 14. In addition, conductive securing members (not shown) pass through the through holes 211 defined in the left end of the lower casing 12 securing the bottom board 21 to lower casing 12. The securing part 22 is a hollow cylinder perpendicularly protruding from one side of the bottom board 21 opposite to the conductive sheet 14. The pivot shaft 23 extends from one end of the securing part 22 away from the bottom board 21 in an opposite direction, parallel to the bottom board 21. The sleeves 24 are sleeved on opposite ends of the pivot shaft 23, and are rotated under external forces. The first wing board 25a and the second wing board 25b are secured on the sleeves 24. The first wing board 25a and the second wing board 25b define a plurality of third through holes 251.

The cover 3 includes a front casing 31, a rear casing 32, and a sub-circuit board 33, a display panel 34, and other electronic components (not shown). The front casing 31 and the rear casing 32 are combined together to form a receiving space to receive the sub-circuit 33, the display panel 34, other electronic components, and a part of the pivot mechanism 2. The front casing 31 defines an opening (not labeled) in the middle enabling the display panel 34 to be exposed out of the front casing 31. The sub-circuit board 33 is configured to control the panel 34 to display information.

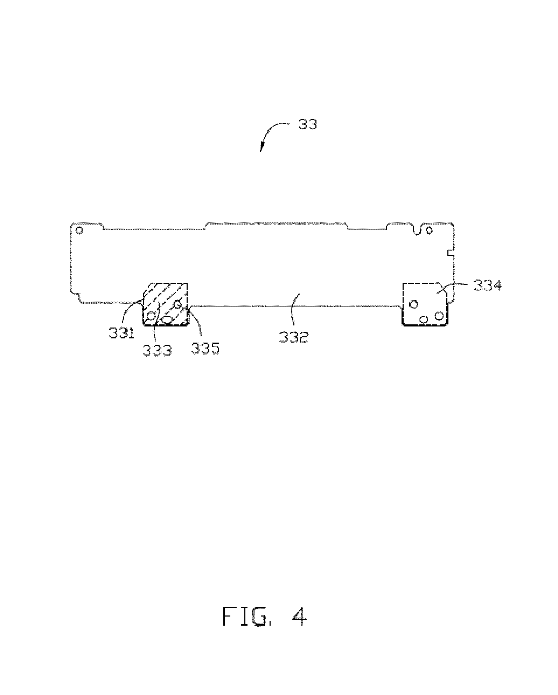

FIGs. 4 and 5 show that sub-circuit board 33 includes a grounded second conductive layer 331, and a second insulated layer 332 covering the second conductive layer 331. The area of the second conductive layer 331 is smaller than the area of the first conductive layer 131. The second conductive layer 331 includes a second conductive part 333 and an insulated part 334. The second conductive part 333 and the insulated part 334 extend from one side of the sub-circuit board 33. The second conductive part 333 and the insulated part 334 are positioned at opposite ends of the sub-circuit board 33. The second conductive part 333 is exposed out of the second insulated layer 332 that covers the insulated part 334. The shapes of the second conductive part 333 and the insulated part 334 match the shapes of the first wing board 25a and the second wing board 25b. The second conductive part 333 and the insulated part 334 define a plurality of fourth through holes 335, the through holes 225 correspond to the third through holes 251. A plurality of securing members (not shown) pass through the third through holes 251 and the fourth through holes 335 securing the second conductive part 333 and the insulated part 334 to the first wing board 25a and the second wing board 25b. As a result, the second conductive part 33 is electrically connected to the first wing board 25a so that the second conductive part 33 is electrically connected to the pivot mechanism 2. The second insulated layer 331 covers the insulated part 334 so that the probability of electro-static discharge (ESD) flowing from the pivot mechanism 2 to the sub-circuit board 33 is diminished.

In the above-described electronic device 100, the first conductive layer 131 of the main circuit board 13 is electrically connected to the pivot mechanism 2 via the conductive sheet 14 and the bottom board 21. The second conductive layer 331 of the sub-circuit bard 33 is electrically connected to the pivot mechanism 2 via the second conductive part 333 and the first wing board 25a. As a result, the second conductive layer 331 is electrically connected to the first conductive layer 131and the area of the second conductive layer 331 increases. Because the area of the second conductive layer 331 is smaller than that of the first conductive layer 131, when ESD occurs on the second conductive 331, an amount of the ESD will be transmitted to ground. The remainder of the ESD will be transmitted to the first conductive layer 131 and then transmitted to the ground via the pivot mechanism 2. As a result, the capacity of ESD protection for the sub-circuit board 33 is improved.

In another embodiment, the first conductive layer 131 of the main circuit board 131 is connected to the pivot mechanism by directly connecting the first conductive part 133 to the bottom board 21, and the conductive sheet 14 is omitted.

Furthermore, in order to improve the capacity of ESD protection, electronic components of the sub-circuit board 33, such as ICs, diodes, and audio cards, which are easily damaged by ESD, are secured to positions of sub-circuit board 33 away from the second conductive part 333. As a result, a path for transmitting the ESD from the joint of the pivot mechanism 2 and the second conductive part 333 to these electronic components is maximized, and the disruption of the ESD decreases.

As described above, the electronic device 100 using the pivot mechanism 2 to electrically connect the second conductive layer 331 to the first conductive layer to increase the area conduction, such that the capacity of ESD protection for the sub-circuit board is improved.

Further alternative embodiments will become apparent to those skilled in the art without departing from the spirit and scope of what is claimed. Accordingly, the present invention should be deemed not to be limited to the above detailed description, but rather only by the claims that follow and equivalents thereof.

## Claims

1. An electronic device, comprising:
a main body;
a cover;
a pivot mechanism;
a main circuit board received in the main body; and
a sub-circuit board received in the cover;
wherein the pivot mechanism is conductive, the main circuit board comprises a first grounded conductive layer, the sub-circuit board comprises a second grounded conductive layer, the first conductive layer is electrically connected to the second conductive layer via the pivot mechanism.

2. The electronic device of claim 1, wherein the area of the first conductive layer is larger than the area of the second conductive layer.

3. The electronic device of claim 1 or 2, wherein the first conductive layer comprises a first conductive part electrically connected to the pivot mechanism, the main circuit board comprises a first insulated layer covered on the first conductive layer, the first conductive part is exposed out of the first insulated layer.

4. The electronic device of claim 3, wherein the pivot mechanism comprises a bottom board, the bottom board is secured to the first conductive part so as to electrically connect to the first conductive layer.

5. The electronic device of claim 1, 2, 3 or 4, wherein the second conductive layer comprises a second conductive part electrically connected to the pivot mechanism, the sub-circuit board comprises a second insulated layer covered on the second conductive layer, the second conductive part is exposed out of the second insulated layer.

6. The electronic device of claim 5, wherein the pivot mechanism further comprises a first wing board, the first wing board is secured to the second conductive part so as to electrically connect to the second conductive layer.

7. The electronic device of claim 6, wherein the shape of the second conductive part matches the shape of the first wing board.

8. The electronic device of claim 5, 6 or 7, wherein the second conductive layer further comprises an insulated part covered by the second insulated layer, the pivot mechanism further comprises a second wing board, the insulated part is secured to the second wing board.

9. The electronic device of claim 8, wherein the shape of the insulated part matches the shape of the second wing board.

10. The electronic device of any preceding claim, wherein the pivot mechanism rotatably connects the cover to the main body.
